# EUROPÄISCHE PATENTANMELDUNG

(11) **EP 0 776 064 A2**
(43) Veröffentlichungstag der Anmeldung: **28.05.1997**
(21) Anmeldenummer: 96108349.0
(22) Anmeldetag: 24.05.1996
(51) Int. Cl.: H01R 4/02

(54) **Lötstift, insbesondere zur Verwendung in einem Spulenkörper**

(30) Priorität: 31.07.1995 DE 29512324 U
(71) Anmelder: Weiner, René, 51702 Bergneustadt (DE)
(72) Erfinder: Weiner, René, 51702 Bergneustadt (DE)
(74) Vertreter: Schaumburg, Thoenes & Thurn

(57) **Zusammenfassung**

Die Erfindung betrifft einen Lötstift, insbesondere zur Verwendung in einem Spulenkörper, mit einem länglichen Körper aus leitfähigem Material, dessen Endabschnitt zum Verlöten in einem Aufnahmeloch einer Leiterplatte vorgesehen ist und der mindestens einen weiteren Abschnitt zum Anwickeln eines Drahtes hat. Der Endabschnitt hat in axialer Richtung annähernd gleichen Querschnitt hat, dessen Umriß durch zwei einander gegenüberstehende Geraden gebildet ist, die durch bogenförmige Begrenzungslinien verbunden sind. Die Seitenflächen des Endabschnitts, welche die bogenförmigen Begrenzungslinien enthalten, sind mit einer Riffelung versehen.

## Beschreibung

Die Erfindung betrifft einen Lötstift, insbesondere zur Verwendung in einem Spulenkörper, mit einem länglichen Körper aus leitfähigem Material, dessen Endabschnitt zum Verlöten in einem Aufnahmeloch einer Leiterplatte vorgesehen ist und der mindestens einen weiteren Abschnitt zum Anwickeln eines Drahtes hat.

Ein derartiger Lötstift ist z.B. aus der DE-OS 39 36 110 A1 bekannt. Der längliche Körper des dort beschriebenen Lötstiftes hat im wesentlichen eine Vierkantform.

Zum Stand der Technik gehören weiterhin Lötstifte mit einem im wesentlichen zylinderförmigen Körper. Diese Zylinderform hat den Nachteil, daß der Stift beim Einlöten in ein Aufnahmeloch einer Leiterplatte durch entweichendes Gas aus diesem herausgedrückt werden kann.

Die Vierkantform besitzt gegenüber der Zylinderform den Vorteil, daß die beim Löten entstehenden Gase problemlos zwischen Aufnahmeloch und den Seitenflächen des Vierkantstiftes entweichen können. Weiterhin besitzt ein Stift mit Vierkantform den Vorteil, daß die Kanten beim Anwickeln eines Drahtes als Abrißkanten genutzt werden können. Durch diese Kanten lassen sich auch die Lötzeiten verkürzen, da bei lackierten Drähten der Lack an den Kanten abgerieben wird. Der Nachteil des Vierkantstiftes besteht darin, daß der Stift das Aufnahmeloch nur an höchstens vier Punkten berührt. Dadurch kann es insbesondere bei Aufnahmelöchern in spröden Kunststoffen zum Ausreißen des Aufnahmeloches kommen. Die gesamte Stabilität des Vierkantstiftes ist geringer als die eines zylindrischen Stiftes.

Es ist Aufgabe der Erfindung, einen Lötstift anzugeben, der eine hohe Lagestabilität im Aufnahmeloch hat und eine gute Lötbarkeit gewährleistet.

Diese Aufgabe wird für einen Lötstift der eingangs genannten Art dadurch gelöst, daß zumindest der Endabschnitt in axialer Richtung annähernd gleichen Querschnitt hat, dessen Umriß durch zwei einander gegenüberstehende Geraden gebildet ist, die durch bogenförmige Begrenzungslinien verbunden sind, und daß Seitenflächen des Endabschnitts, welche die bogenförmigen Begrenzungslinien enthalten, mit einer Riffelung versehen sind.

Beim Lötstift nach der Erfindung wird es durch die bogenförmigen Seitenflächen möglich, den Lötstift in einem Aufnahmeloch stabil zu befestigen. Durch die ebenen Flächen, die die gegenüberstehenden Geraden enthalten, kann das beim Löten entstehende Gas leicht entweichen, ohne daß der Lötstift aus dem Aufnahmeloch herausgedrückt wird.

Die Riffelung gemäß der Erfindung erhöht weiterhin die Stabilität des Lötstiftes im Aufnahmeloch, denn beim Löten mit ei-ner Temperatur von ungefähr 300°C wird Kunststoff, der mit dem Lötstift in Berührung steht, aufgeschmolzen und dringt in diese Riffelung ein. Im Bereich der Riffelung entsteht somit eine formschlüssige Verbindung zwischen Lötstift und Leiterplatte, wodurch die Auszugskraft des Lötstiftes erhöht wird.

Außerdem kommt es beim Verlöten des Lötstiftes mit einer Leiterbahn durch die Riffelung zu einer vergrößerten Kontaktfläche, da das Lötzinn in den Zwischenraum zwischen Aufnahmeloch und Lötstift hineinfließen kann.

Die Erfindung betrifft weiterhin einen Spulenkörper mit einem Mittelteil zur Aufnahme einer Wicklung, an dem mindestens eine Anschlußleiste zur Aufnahme mindestens eines Lötstiftes vorgesehen ist, der einen länglichen Körper aus leitfähigem Material hat, dessen Endabschnitt zum Verlöten in einem Aufnahmeloch einer Leiterplatte vorgesehen ist, und der mindestens einen weiteren Abschnitt zum Anwickeln eines Drahtes hat. Der Spulenkörper ist dadurch gekennzeichnet, daß zumindest der Endabschnitt des Lötstiftes in axialer Richtung annähernd gleichen Querschnitt hat, dessen Umriß durch zwei einander gegenüberstehende Geraden gebildet ist, die durch bogenförmige Begrenzungslinien verbunden sind, und daß Seitenflächen des Endabschnitts, welche die bogenförmigen Begrenzungslinien enthalten, mit einer Riffelung versehen sind.

Durch die Verwendung derartiger Lötstifte wird eine höhere Stabilität des Spulenkörpers auf der Leiterplatte erreicht.

Ein Ausführungsbeispiel der Erfindung wird im folgenden anhand der Zeichnungen erläutert. Dabei zeigen:
- Figur 1: einen Spulenkörper mit Lötstiften,
- Figur 2: den Querschnitt eines Lötstiftes, und
- Figur 3: die Seitenansicht des Lötstiftes.

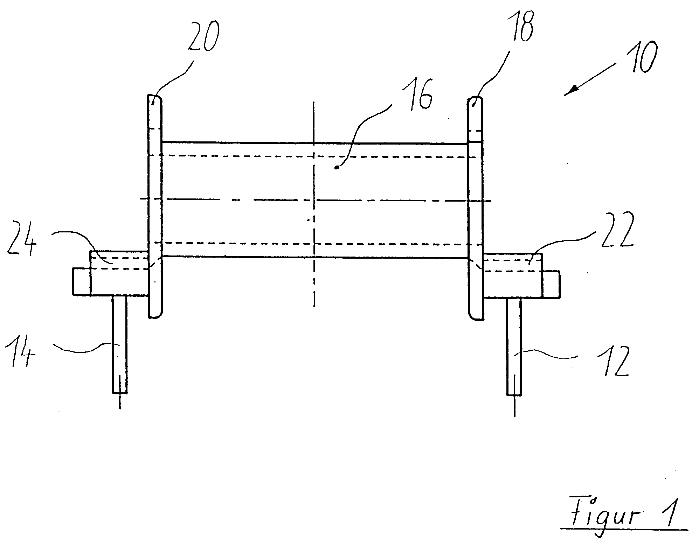

Figur 1 zeigt einen Spulenkörper 10 mit Lötstiften 12 und 14. Der Spulenkörper 10 hat ein Mittelteil 16 zur Aufnahme von nicht dargestellten Drahtwicklungen. Das Mittelteil 16 ist begrenzt durch Flansche 18 und 20, die ein Herunterrutschen der nicht dargestellten Drahtwicklungen vom Mittelteil 16 verhindern sollen und an denen Anschlußleisten 22 und 24 ausgebildet sind, welche jeweils eine Reihe von Lötstiften aufnehmen, von denen in Figur 1 die Lötstifte 12 und 14 sichtbar sind.

An den Lötstiften 12 und 14 werden im Bereich unterhalb der Anschlußleisten 22 bzw. 24 die Enden der Drahtwicklungen angewickelt und/oder angelötet (in Figur 1 nicht dargestellt). Die freien Enden der Lötstifte 12 und 14 dienen der Befestigung des Spulenkörpers 10 auf einer ebenfalls nicht dargestellten Leiterplatte. Die Lötstifte 12 und 14 werden in der Regel mit Leiterbahnen auf der Leiterplatte verlötet.

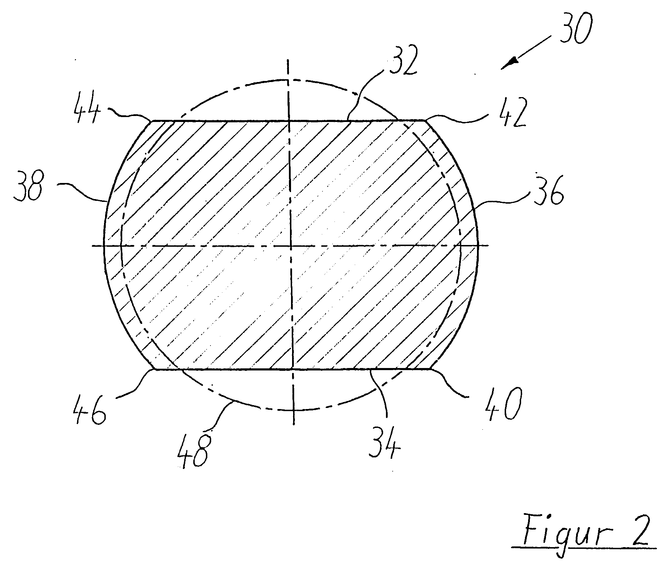

Figur 2 zeigt einen Querschnitt 30 des Lötstiftes 12 bzw. 14 nach der Erfindung. Zwei einander gegenüberstehende Geraden 32 und 34 sowie zwei bogenförmige Begrenzungslinien 36 und 38 bilden den Umriß des Querschnitts 30. An den Berührungspunkten der Geraden 32 und 34 mit den bogenförmigen Begrenzungslinien 36 und 38 bilden sich scharfe Kanten 40 bis 46 aus. Diese Kanten 40 bis 46 sind trotz der bogenförmigen Begrenzungslinien 36 und 38 noch ausreichend scharf, so daß ein Abreißen eines Anwickeldrahtes beim Anwickeln ermöglicht wird.

Weiterhin ist in Figur 2 der Durchmesser 48 eines Aufnahmeloches angedeutet, das sich in der nicht dargestellten Leiterplatte befindet. Da der Durchmesser 48 kleiner ist als der Außendurchmesser der Lötstifte 12 und 14, muß beim Einbringen derselben in das Aufnahmeloch leichter Druck ausgeübt werden. Der Lötstift sitzt dann fest im Aufnahmeloch und kann durch beim Löten entstehende Gase nicht aus dem Aufnahmeloch gedrückt werden.

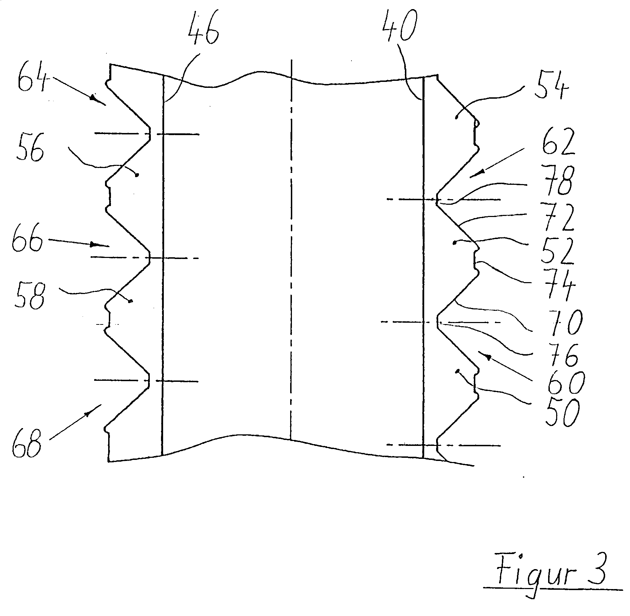

Figur 3 zeigt eine Seitenansicht der Endabschnitte des Lötstiftes 12 bzw. 14 nach der Erfindung. Deutlich zu erkennen ist die Riffelung der Seitenflächen. Die Riffelung wird durch Vorsprünge 50 bis 58 gebildet, zwischen denen sich Kerben 60 bis 68 befinden. Flanken 70 und 72 am Vorsprung 52 sind annähernd rechtwinklig zueinander angeordnet. Der Vorsprung 52 wird durch eine Kopffläche 74 und ist in Längsrichtung des Lötstiftes von Kerbenfußflächen 76 und 78 begrenzt.

Die Vorsprünge 50 bis 54 sowie die Kerben 60 und 62 sind gegenüber den Vorsprüngen 56 und 58 sowie den Kerben 64 bis 68 der jeweils gegenüberliegenden Seitenfläche so versetzt, daß sich jeweils eine Vorsprungskopffläche und eine Kerbenfußfläche gegenüberliegen. Durch diese Maßnahme wird das Anwickeln eines Endes einer Drahtwicklung erleichtert.

## Patentansprüche

1. Lötstift (12, 14), insbesondere zur Verwendung in einem Spulenkörper (10), mit einem länglichen Körper aus leitfähigem Material, dessen Endabschnitt zum Verlöten in einem Aufnahmeloch einer Leiterplatte vorgesehen ist und der mindestens einen weiteren Abschnitt zum Anwickeln eines Drahtes hat, dadurch **gekennzeichnet**, daß zumindest der Endabschnitt in axialer Richtung annähernd gleichen Querschnitt (30) hat, dessen Umriß durch zwei einander gegenüberstehende Geraden (32, 34) gebildet ist, die durch bogenförmige Begrenzungslinien (36, 38) verbunden sind, und daß Seitenflächen des Endabschnitts, welche die bogenförmigen Begrenzungslinien enthalten, mit einer Riffelung versehen sind.

2. Lötstift (12, 14) nach Anspruch 1, dadurch **gekennzeichnet**, daß der Körper in seiner gesamten Länge den Querschnitt (30) des Endabschnittes hat.

3. Lötstift (12, 14) nach Anspruch 1 oder 2, dadurch **gekennzeichnet**, daß die Seitenflächen an ihren Übergängen zu den die Geraden enthaltenden ebenen Flächen Kanten (40 - 46) bilden, die als Abrißkanten beim Anwickeln eines Drahtes dienen.

4. Lötstift (12, 14) nach einem der vorhergehenden Ansprüche, dadurch **gekennzeichnet**, daß die bogenförmigen Begrenzungslinien (36, 38) Kreisbögen sind, deren Radien gleich groß sind und deren Mittelpunkte vorzugsweise zusammenfallen.

5. Lötstift nach Anspruch 4, dadurch **gekennzeichnet**, daß die Seitenflächen Teilzylinder-Mantelflächen bilden.

6. Lötstift nach Anspruch 4 oder 5, dadurch **gekennzeichnet**, daß die Riffelung durch Rillen (60 - 68) gebildet ist, deren Innendurchmesser kleiner als der Durchmesser des Aufnahmelochs in der Leiterplatte und deren Außendurchmesser größer als der Durchmesser (48) des Aufnahmelochs in der Leiterplatte ist.

7. Lotstift (12, 14) nach einem der Ansprüche 1 bis 6, dadurch **gekennzeichnet**, daß die Riffelung der Seitenflächen zueinander in axialer Richtung versetzt ist.

8. Spulenkörper (10) mit einem Mittelteil (16) zur Aufnahme einer Wicklung, an dem mindestens eine Anschlußleiste (22, 24) zur Aufnahme mindestens eines Lötstiftes (12, 14) vorgesehen ist, der einen länglichen Körper aus leitfähigem Material hat, dessen Endabschnitt zum Verlöten in einem Aufnahmeloch einer Leiterplatte vorgesehen ist und der mindestens einen weiteren Abschnitt zum Anwickeln eines Drahtes hat, dadurch **gekennzeichnet**, daß zumindest der Endabschnitt in axialer Richtung annähernd gleichen Querschnitt (30) hat, dessen Umriß durch zwei einander gegenüberstehende Geraden (32, 34) gebildet ist, die durch bogenförmige Begrenzungslinien (36, 38) verbunden sind, und daß Seitenflächen des Endabschnitts, welche die bogenförmigen Begrenzungslinien enthalten, mit einer Riffelung versehen sind.

9. Spulenkörper (10) gemäß Anspruch 8, dadurch **gekennzeichnet**, daß der Körper in seiner gesamten Länge den Querschnitt (30) des Endabschnittes hat.

10. Spulenkörper (10) gemäß Anspruch 6 oder 7, dadurch **gekennzeichnet**, daß die Seitenflächen an ihren Übergängen zu den die Geraden enthaltenden ebenen Flächen Kanten (40 - 46) bilden, die als Abrißkanten beim Anwickeln eines Drahtes dienen.

11. Spulenkörper (10) nach einem der Ansprüche 8 bis 10, dadurch **gekennzeichnet**, daß die bogenförmigen Begrenzungslinien (36, 38) Kreisbögen sind, deren Radien gleich groß sind und deren Mittelpunkte vorzugsweise zusammenfallen.

12. Spulenkörper (10) nach einem der Ansprüche 8 bis 11, dadurch **gekennzeichnet**, daß die Seitenflächen Teilzylinder-Mantelflächen bilden.

13. Spulenkörper (10) nach einem der Ansprüche 8 bis 12, dadurch **gekennzeichnet**, daß die Riffelung durch Rillen (60 - 68) gebildet ist, deren Innendurchmesser kleiner als der Durchmesser des Aufnahmelochs in der Leiterplatte und deren Außendurchmesser größer als der Durchmesser (48) des Aufnahmelochs in der Leiterplatte ist.

14. Spulenkörper (10) nach einem der Ansprüche 8 bis 13, dadurch **gekennzeichnet**, daß die Riffelung der Seitenflächen zueinander in axialer Richtung versetzt ist.
